# EUROPÄISCHE PATENTSCHRIFT

(11) **EP 3 185 418 B1**
(45) Veröffentlichungstag und Bekanntmachung des Hinweises auf die Patenterteilung: **24.02.2021**
(21) Anmeldenummer: 16205964.6
(22) Anmeldetag: 21.12.2016
(51) Int. Cl.: H03J 3/04, H04B 1/40, H03D 7/16

(54) **VERFAHREN ZUM BETREIBEN EINER SELEKTIONSSCHALTUNGSVORRICHTUNG FÜR SIGNALE**
METHOD FOR OPERATING A SELECTION SWITCHING DEVICE FOR SIGNALS
PROCÉDÉ DE FONCTIONNEMENT D'UN DISPOSITIF DE CIRCUIT DE SÉLECTION POUR SIGNAUX

(30) Priorität: 21.12.2015 DE 102015016462
(43) Veröffentlichungstag der Anmeldung: 28.06.2017
(73) Patentinhaber: Tesat Spacecom GmbH & Co. KG, 71522 Backnang (DE)
(72) Erfinder: Auer, Erich, 74354 Besigheim (DE)
(74) Vertreter: LKGLOBAL Lorenz & Kopf PartG mbB Patentanwälte

(56) Entgegenhaltungen:
- JP-B2- 3 088 105
- US-A1- 2005 260 961

## Beschreibung

### TECHNISCHES GEBIET

Die Erfindung betrifft ein Verfahren zum Betrieb einer Selektionsschaltungsvorrichtung für Signale, eine solche Selektionsschaltungsvorrichtung und ein Nachrichtenübertragungssystem mit einer solchen Selektionsschaltungsvorrichtung.

### HINTERGRUND DER ERFINDUNG

Ein Hohlleiterfilter ist ein in der Mikrowellentechnik eingesetzter passiver Filter in Form eines speziell ausgestatteten Hohlleiters. Er dient dazu bestimmte Frequenzen der sich im Hohlleiter ausbreitenden elektromagnetischen Welle zu unterdrücken oder passieren zu lassen. Hohlleiterfilter können unter anderem als Baugruppe bei größeren Sendeanlagen, Radaranlagen und bei Kommunikationssatelliten eingesetzt werden.

Insbesondere bei Raumfahrtanwendungen gibt es sehr große Temperaturschwankungen, die sich als starke Volumenänderungen von Hohlleiterbauelementen und Hohlleiterfiltern bemerkbar machen können. Eine Lösung zur Vermeidung von Temperaturabhängigkeiten (Drift) von Hohleiterfiltern ist die Auswahl von Materialien, die von Hause aus einen sehr geringen Temperatur-Ausdehnungskoeffizienten haben, wie z.B. Invar. Materialien wie Invar weisen jedoch die Nachteile auf, dass sie schwer, teuer und schlecht bearbeitbar sind.

Eine andere Lösung zur Vermeidung von Temperaturabhängigkeiten von Hohleiterfiltern ist der Einsatz von zusätzlichen mechanischen Elementen, wie Bimetall-Strukturen, die die temperaturabhängige Ausdehnung der Hohlleiter durch eine in der Wirkung entgegengesetzte, temperaturabhängige Auslenkung der Bimetall-Struktur physikalisch kompensieren. Zum Beispiel DE 43 19 886 C1 offenbart eine Anordnung zum Kompensieren temperaturabhängiger Volumenänderungen eines Hohlleiters, wobei der Hohlleiter in einen Rahmen eingespannt ist, dessen temperaturabhängige Ausdehnung geringer ist als die des Hohlleiters. Der Hohlleiter ist an mindestens zwei einander gegenüberliegenden Stellen seiner Wandung kraftschlüssig mit dem Rahmen verbunden und die kraftschlüssigen Verbindungen zwischen Rahmen und Hohlleiter erfolgen über Distanzstücke, welche aus einer unterschiedlichen Wärmeausdehnung zwischen Rahmen und Hohlleiter resultierende Druck- oder Zugkräfte auf die Hohlleiterwandung übertragen und dort Verformungen hervorrufen. Eine solche mechanische Lösung ist im Folgenden dargestellt, weist aber unter anderem den Nachteil auf, dass sie aufwändig in der Herstellung und Handhabung sind.

JP 3088105B2 beschreibt einen Bandpass mit Temperaturkompensation, um eine Mittenfrequenz des Bandpasses konstant zu halten.

US 2005/0260961 A1 beschreibt eine Abstimmvorrichtung (tuner) mit einer Temperaturkompensation. Die Umgebungstemperatur wird erfasst, um eine Veränderung einer Mittenfrequenz eines Bandpasses zu ermitteln und eine Frequenzveränderung eines Oszillators zu bestimmen, um die Veränderung der Mittenfrequenz auszugleichen.

### ZUSAMMENFASSUNG DER ERFINDUNG

Es ist eine Aufgabe der Erfindung ein einfacheres Betreiben einer Selektionsschaltungsvorrichtung zu ermöglichen.

Diese Aufgabe wird durch ein Verfahren zum Betrieb einer Selektionsschaltungsvorrichtung für Signale, eine solche Selektionsschaltungsvorrichtung und ein Nachrichtenübertragungssystem mit einer solchen Selektionsschaltungsvorrichtung gemäß den unabhängigen Ansprüchen gelöst. Vorteilhafte Ausführungsformen und Weiterbildungen sind den Unteransprüchen und der nachfolgenden Beschreibung zu entnehmen.

Es wird vorgeschlagen, ein Verfahren zum Betrieb einer Selektionsschaltungsvorrichtung für Signale bereitzustellen. Das Verfahren umfasst die folgenden Schritte, nicht notwendigerweise in dieser Reihenfolge:
a) Bestimmen einer aktuellen Temperatur im Bereich der Selektions-schaltungsvorrichtung,
b) Bestimmen einer Signalverschiebung der Selektionsschaltungsvorrichtung aufgrund der aktuellen Temperatur,
c) Hinzufügen der Signalverschiebung zu einem Eingangssignal der Selektionsschaltungsvorrichtung, um ein kompensiertes Signal zu erhalten, bei welchem die Signalverschiebung aufgrund der aktuellen Temperatur kompensiert ist, und
d) Entfernen der Signalverschiebung von einem Ausgangssignal der Selektionsschaltungsvorrichtung, um ein korrigiertes Signal zu erhalten, bei welchem die Kompensation korrigiert ist.

Das Verfahren zum Betrieb einer Selektionsschaltungsvorrichtung für Signale gemäß der vorliegenden Erfindung kann zunächst eine auftretende Temperaturabhängigkeit bzw. Temperaturdrift in Kauf nehmen. Am Beispiel eines der Hohlleiterfilters als Selektionsschaltungsvorrichtung kann durch Messung der aktuellen Temperatur die aktuelle Temperaturdrift, die in einer Frequenzverschiebung der Filterfunktion resultiert, bestimmt werden. Diese Frequenzverschiebung kann den Eingangssignalen mit gleichem Vorzeichen aufgeprägt und bei den Ausgangssignalen mit entgegengesetztem Vorzeichen aufgeprägt und damit schlussendlich kompensiert werden. Auf diese Weise wird eine Kompensation der Temperaturdrift eines sog. Low Cost Hohlleiterfilters erreicht. Low Cost bezieht sich auf geringere Kosten gegenüber z.B. einem Hohlleiterfilter aus Invar. Ein Low Cost Hohlleiterfilter kann z.B. in Halbschalentechnik aus Aluminium (gefräst oder in Druckguß) oder in Kunststoff-Druckguß mit anschließender Oberflächen-Metallisierung aufgebaut sein.

Das Verfahren zum Betrieb einer Selektionsschaltungsvorrichtung gemäß der vorliegenden Erfindung kann auch als "Hybride Temperaturkompensationstechnik" bezeichnet werden und ermöglicht, dass Low Cost Hohlleiterfilter ohne weitere technische Nachteile verwendet werden können, d. h. es wird ein signifikanter Kostenvorteil ohne technische Nachteile erreicht. Der Mehraufwand, der durch die Anwendung der "Hybriden Temperaturkompensationstechnik" in Systemen entsteht, ist sehr gering, da vorhandene Einrichtung mit benutzt werden können (z. B. Controller, Synthesizer). Das Verfahren zum Betrieb einer Selektionsschaltungsvorrichtung gemäß der vorliegenden Erfindung ist auch mechanischen Lösungen (z.B. Bimetall-Struktur) überlegen, da es weniger aufwändig in der Herstellung und der Handhabung ist.

In einer Ausführungsform ist die Signalverschiebung eine Frequenzverschiebung, das Eingangssignal ein Eingangsspektrum, und das Ausgangssignal ein Ausgangsspektrum. Das Hinzufügen der Signalverschiebung kann eine Addition sein, das Entfernen der Signalverschiebung kann eine Subtraktion sein.

In einer Ausführungsform ist die Selektionsschaltungsvorrichtung eine frequenzselektive Einheit oder ein Frequenz-Multiplexer. Ein Multiplexer ist eine Selektionsschaltung in der analogen und digitalen Elektronik, mit der aus einer Anzahl von Eingangssignalen eines ausgewählt und an den Ausgang durchgeschaltet werden kann. Multiplexer sind vergleichbar mit Drehschaltern, die nicht von Hand, sondern mit elektronischen Signalen gestellt werden. In einer Ausführungsform liegt der Frequenz-Multiplexer in Form eines passiven Filters, eines aktiven Filters, eines digitalen Filters oder einer Mischform vor. Der passive Filter kann ein Hohlleiterfilter sein.

In einer Ausführungsform wird die Signalverschiebung durch eine Annäherungsberechnung bestimmt. In einer Ausführungsform wird die Signalverschiebung anhand einer Datenbank bestimmt.

In einer Ausführungsform werden das kompensierte Signal und das korrigierte Signal in Vorwärts- und Rückwärtsrichtung durch die Selektionsschaltungsvorrichtung zeitsynchron aktualisiert. Da die Verschiebungen des Eingangssignales und des Ausgangssignales auf diese Weise zeitsynchron oder zeitgleich erfolgen, wird nach außen hin das Signal durch die Temperaturkompensation nicht verfälscht. Eine Aktualisierungsrate für das kompensierte Signal und das korrigierte Signal kann größer sein als das Doppelte der Signalbeschränkung einer Veränderung der aktuellen Temperatur.

In einer Ausführungsform weist das Verfahren zum Betrieb einer Selektionsschaltungsvorrichtung weiterhin die folgenden Schritte, nicht notwendigerweise in dieser Reihenfolge auf:
e) Bestimmen eines gewünschten Signalbereichs des Eingangssignals und/oder des Ausgangssignals der Selektionsschaltungsvorrichtung in Abhängigkeit vom Einsatzzweck der Selektionsschaltungsvorrichtung, und
f) Hinzufügen einer weiteren Signalverschiebung zu dem Eingangssignal und/oder zu dem Ausgangssignal, um das Eingangssignal und/oder das Ausgangssignal in den gewünschten Signalbereich zu verschieben.

In anderen Worten, die Signalverschiebung kann zusätzlich zur Kompensation der Temperaturdrift der Selektionsschaltungsvorrichtung dazu genutzt werden, sowohl das Eingangssignal als auch das Ausgangssignal in einen Frequenzbereich zu verschieben, der eine möglichst vorteilhafte Realisierung der Selektionsschaltungsvorrichtung z.B. in Form eines passiven oder aktiven oder digitalen Filters oder einer Mischform derselben erlaubt.

Es wird weiterhin vorgeschlagen, eine Selektionsschaltungsvorrichtung bereitzustellen, die gestaltet ist zum Bestimmen einer Signalverschiebung der Selektionsschaltungsvorrichtung aufgrund einer aktuellen Temperatur, zum Hinzufügen der Signalverschiebung zu einem Eingangssignal der Selektionsschaltungsvorrichtung, und zum Entfernen der Signalverschiebung von einem Ausgangssignal der Selektionsschaltungsvorrichtung, um die Signalverschiebung aufgrund der aktuellen Temperatur im Bereich der Selektionsschaltungsvorrichtung zu kompensieren.

In einer Ausführungsform werden obige Schritte auf dieselbe Weise in Vorwärts- und Rückwärtsrichtung verwendet. In einer Ausführungsform ist die Selektionsschaltungsvorrichtung ein Verbund aus mehreren Multiplexern. Das Bestimmen einer aktuellen individuellen Temperatur im Bereich der Multiplexer kann für jeden Multiplexer einzeln erfolgen. Auch das Bestimmen der individuellen Signalverschiebung aufgrund der aktuellen individuellen Temperatur kann für jeden Multiplexer einzeln erfolgen. Auch das kompensierte individuelle Signal, bei welchem die Signalverschiebung aufgrund der aktuellen Temperatur kompensiert ist, kann für jeden Multiplexer einzeln durch Hinzufügen der individuellen Signalverschiebung zu einem individuellen Eingangssignal des Multiplexers erhalten werden. Das korrigierte individuelle Signal, bei welchem die Kompensation korrigiert ist, kann ebenfalls für jeden Multiplexer einzeln durch Entfernen der individuellen Signalverschiebung von einem individuellen Ausgangssignal des Multiplexers erhalten werden.

In einer Ausführungsform ist die Selektionsschaltungsvorrichtung aus einem Leichtmetall, einer Leichtmetalllegierung, Kunststoff und/oder einem Faserverbundwerkstoff hergestellt.

Es wird weiterhin vorgeschlagen, ein Nachrichtenübertragungssystem bereitzustellen, welches eine Selektionsschaltungsvorrichtung wie oben beschrieben aufweist. In einer Ausführungsform ist die Signalverschiebung eine Frequenzverschiebung, das Eingangssignal ein Eingangsspektrum, und das Ausgangssignal ein Ausgangsspektrum. In einer Ausführungsform ist die Selektionsschaltungsvorrichtung ein Multiplexer. In einer Ausführungsform liegt der Multiplexer in Form eines passiven Filters, eines aktiven Filters, eines digitalen Filters oder einer Mischform vor. Der passive Filter kann ein Hohlleiterfilter sein.

### KURZE BESCHREIBUNG DER ZEICHNUNGEN

Weitere Merkmale, Vorteile und Anwendungsmöglichkeiten der vorliegenden Erfindung ergeben sich aus der nachfolgenden Beschreibung der Ausführungsbeispiele und den Figuren. Dabei bilden alle beschriebenen und/oder bildlich dargestellten Merkmale für sich und in beliebiger Kombination den Gegenstand der Erfindung auch unabhängig von ihrer Zusammensetzung in den einzelnen Ansprüchen oder deren Rückbezügen. In den Figuren stehen gleiche Bezugszeichen für gleiche oder ähnliche Objekte.
- Fig. 1: zeigt eine schematische Ansicht eines beispielhaften Verfahrens zum Betrieb einer Selektionsschaltungsvorrichtung für Signale.
- Fig. 2: zeigt eine schematische Ansicht eines beispielhaften Blockschaltbildes eines Nachrichtenübertragungssystems.

### DETAILLIERTE BESCHREIBUNG EXEMPLARISCHER AUSFÜHRUNGSFORMEN

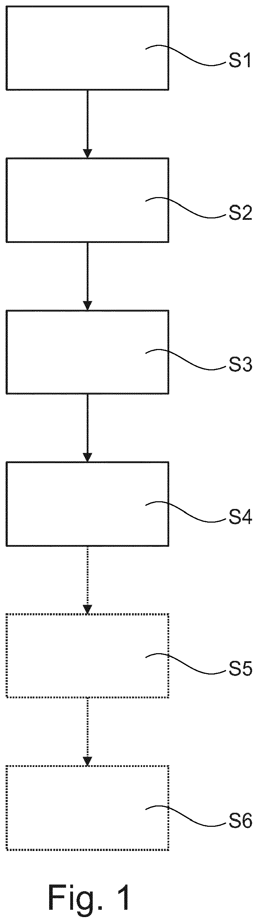

Fig. 1 zeigt eine schematische Ansicht eines beispielhaften Verfahrens zum Betrieb einer Selektionsschaltungsvorrichtung für Signale. Das Verfahren umfasst die folgenden Schritte, nicht notwendigerweise in dieser Reihenfolge:

| | |
|---|---|
| Schritt S1, | Bestimmen einer aktuellen Temperatur im Bereich der Selektionsschaltungsvorrichtung, |
| Schritt S2, | Bestimmen einer Signalverschiebung der Selektionsschaltungsvorrichtung aufgrund der aktuellen Temperatur, |
| Schritt S3, | Hinzufügen der Signalverschiebung zu einem Eingangssignal der Selektionsschaltungsvorrichtung, um ein kompensiertes Signal zu erhalten, bei welchem die Signalverschiebung aufgrund der aktuellen Temperatur kompensiert ist, und |
| Schritt S4, | Entfernen der Signalverschiebung von einem Ausgangssignal der Selektionsschaltungsvorrichtung, um ein korrigiertes Signal zu erhalten, bei welchem die Kompensation korrigiert ist. |

Das Verfahren zum Betrieb einer Selektionsschaltungsvorrichtung umfasst weiterhin die folgenden optionalen Schritte, nicht notwendigerweise in dieser Reihenfolge:

| | |
|---|---|
| Schritt S5, | Bestimmen eines gewünschten Signalbereichs des Eingangssignals und/oder des Ausgangssignals der Selektionsschaltungsvorrichtung in Abhängigkeit vom Einsatzzweck der Selektionsschaltungsvorrichtung, und |
| Schritt S6, | Hinzufügen einer weiteren Signalverschiebung zu dem Eingangssignal und/oder zu dem Ausgangssignal, um das Eingangssignal und/oder das Ausgangssignal in den gewünschten Signalbereich zu verschieben. |

Die Selektionsschaltungsvorrichtung ist hier ein Multiplexer in Form eines passiven Filters, wie z.B. ein Hohlleiterfilter. Die Signalverschiebung ist hier eine Frequenzverschiebung, das Eingangssignal ein Eingangsspektrum, und das Ausgangssignal ein Ausgangsspektrum. Die Signalverschiebung kann durch eine Annäherungsberechnung oder anhand einer Datenbank bestimmt werden. Das kompensierte Signal und das korrigierte Signal werden hier in Vorwärts- und Rückwärtsrichtung durch den Multiplexer zeitsynchron aktualisiert, sodass die Verschiebungen des Eingangssignales und des Ausgangssignales zeitsynchron erfolgen und nach außen hin das Signal durch die Temperaturkompensation nicht verfälscht wird.

Durch die Schritte S1 bis S4 wird am Beispiel eines Hohlleiterfilters als Selektionsschaltungsvorrichtung durch Messung der aktuellen Temperatur die aktuelle Temperaturdrift, die in einer Frequenzverschiebung der Filterfunktion resultiert, bestimmt. Diese Frequenzverschiebung kann den Eingangssignalen des Hohlleiterfilters mit gleichem Vorzeichen aufgeprägt und bei den Ausgangssignalen des Hohlleiterfilters mit entgegengesetztem Vorzeichen aufgeprägt und damit schlussendlich kompensiert werden. Auf diese Weise wird eine Kompensation der Temperaturdrift eines sog. Low Cost Hohlleiterfilters aus Aluminium oder Kunststoff erreicht.

Durch die Schritte S5 und S6 wird die Signalverschiebung zusätzlich zur Kompensation der Temperaturdrift des Multiplexers dazu genutzt, sowohl das Eingangssignal als auch das Ausgangssignal in einen Frequenzbereich zu verschieben, der eine möglichst vorteilhafte Realisierung des Multiplexers erlaubt.

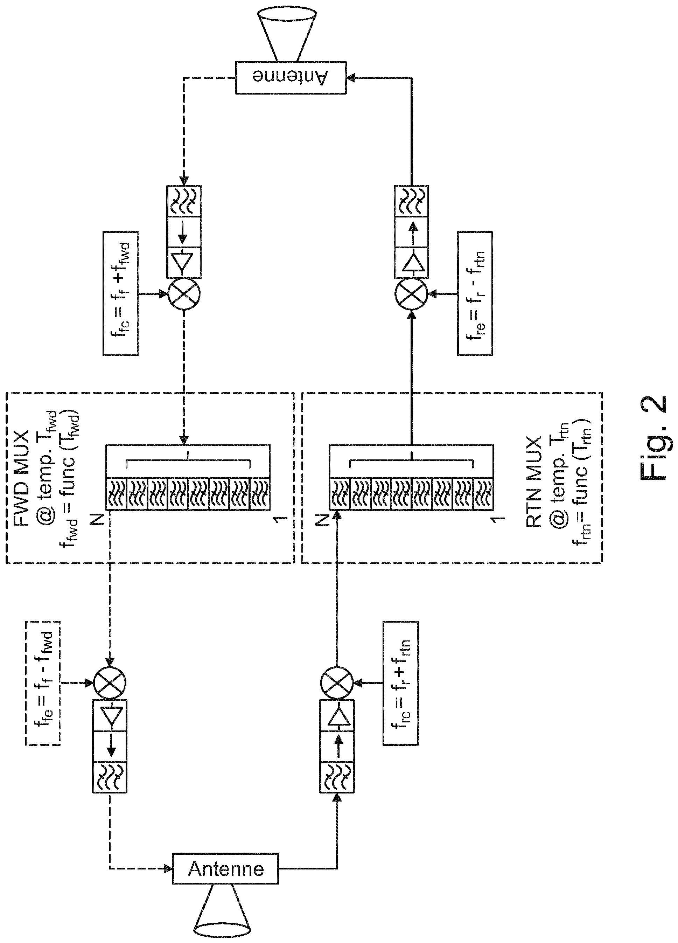

Fig. 2 zeigt eine schematische Ansicht eines beispielhaften Blockschaltbildes eines Nachrichtenübertragungssystems. Das Nachrichtenübertragungssystem umfasst mehrere Multiplexer (MUX), die in Vorwärtsrichtung (FWD) und Rückwärtsrichtung (RTN) verwendet werden können. Die Frequenzverschiebungen ffwd und frtn in Vorwärts- und Rückwärtsrichtung hängen von den aktuellen Temperaturen Tfwd und Trtn in Vorwärts- und Rückwärtsrichtung ab. Die Frequenzverschiebungen ffwd und frtn in Vorwärts- und Rückwärtsrichtung werden zu Eingangssignalen ff und fr in Vorwärts- und Rückwärtsrichtung hinzugefügt bzw. addiert, um ein kompensiertes Signal ffc und frc in Vorwärts- und Rückwärtsrichtung zu erhalten, bei welchem die Signalverschiebung aufgrund der aktuellen Temperatur kompensiert ist. Die Frequenzverschiebungen ffwd und frtn in Vorwärts- und Rückwärtsrichtung werden von Eingangssignalen ff und fr in Vorwärts- und Rückwärtsrichtung entfernt bzw. subtrahiert, um ein korrigiertes Signal ffe und fre in Vorwärts- und Rückwärtsrichtung zu erhalten, bei welchem die Kompensation korrigiert ist.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Ein Verfahren zum Betrieb einer Selektionsschaltungsvorrichtung für Signale, wobei die Selektionsschaltungsvorrichtung ein Hohlleiterfilter ist, aufweisend die folgenden Schritte:
- Bestimmen (S1) einer aktuellen Temperatur im Bereich der Selektionsschaltungsvorrichtung und einer Temperaturdrift, die in einer Frequenzverschiebung einer Filterfunktion der Selektionsschaltungsvorrichtung resultiert,
- Bestimmen (S2) einer Signalverschiebung der Selektionsschaltungsvorrichtung aufgrund der aktuellen Temperatur, wobei die Signalverschiebung eine Frequenzverschiebung ist,
- Hinzufügen (S3) der Signalverschiebung zu einem Eingangssignal der Selektionsschaltungsvorrichtung, um ein kompensiertes Signal zu erhalten, bei welchem die Signalverschiebung aufgrund der aktuellen Temperatur kompensiert ist, wobei das Eingangssignal ein Eingangsspektrum ist, und
- Entfernen (S4) der Signalverschiebung von einem Ausgangssignal der Selektionsschaltungsvorrichtung, um ein korrigiertes Signal zu erhalten, bei welchem die Kompensation korrigiert ist, wobei das Ausgangssignal ein Ausgangsspektrum ist.

2. Verfahren nach einem der vorherigen Ansprüche, wobei die Signalverschiebung durch eine Annäherungsberechnung bestimmt wird.

3. Verfahren nach einem der vorherigen Ansprüche, wobei die Signalverschiebung anhand einer Datenbank bestimmt wird.

4. Verfahren nach einem der vorherigen Ansprüche, wobei das kompensierte Signal und das korrigierte Signal in Vorwärts- und Rückwärtsrichtung durch die Selektionsschaltungsvorrichtung zeitsynchron aktualisiert werden.

5. Verfahren nach einem der vorherigen Ansprüche, weiterhin aufweisend
- ein Bestimmen eines gewünschten Signalbereichs des Eingangssignals und/oder des Ausgangssignals der Selektionsschaltungsvorrichtung in Abhängigkeit vom Einsatzzweck der Selektionsschaltungsvorrichtung, und
- ein Hinzufügen einer weiteren Signalverschiebung zu dem Eingangssignal und/oder zu dem Ausgangssignal, um das Eingangssignal und/oder das Ausgangssignal in den gewünschten Signalbereich zu verschieben.

6. Eine Selektionsschaltungsvorrichtung, welche ein Hohlleiterfilter ist, die gestaltet ist zum Bestimmen einer Signalverschiebung der Selektionsschaltungsvorrichtung aufgrund einer aktuellen Temperatur im Bereich der Selektionsschaltungsvorrichtung und einer Temperaturdrift, die in einer Frequenzverschiebung einer Filterfunktion der Selektionsschaltungsvorrichtung resultiert, wobei die Signalverschiebung eine Frequenzverschiebung ist, zum Hinzufügen der Signalverschiebung zu einem Eingangssignal der Selektionsschaltungsvorrichtung, um ein kompensiertes Signal zu erhalten, bei welchem die Signalverschiebung aufgrund der aktuellen Temperatur kompensiert ist, wobei das Eingangssignal ein Eingangsspektrum ist, und zum Entfernen der Signalverschiebung von einem Ausgangssignal der Selektionsschaltungsvorrichtung, um ein korrigiertes Signal zu erhalten, bei welchem die Kompensation korrigiert ist, wobei das Ausgangssignal ein Ausgangsspektrum ist.

7. Selektionsschaltungsvorrichtung nach dem vorherigen Anspruch, wobei die Selektionsschaltungsvorrichtung ein Frequenz-Multiplexer in Form eines passiven Filters, eines aktiven Filters oder eines digitalen Filters ist.

8. Selektionsschaltungsvorrichtung nach einem der Ansprüche 6 oder 7, wobei die Selektionsschaltungsvorrichtung aus einem Leichtmetall, einer Leichtmetalllegierung, Kunststoff und/oder einem Faserverbundwerkstoff hergestellt ist.

9. Ein Nachrichtenübertragungssystem, aufweisend eine Selektionsschaltungsvorrichtung nach einem der Ansprüche 6 bis 8.

## Claims

1. Method for operating a selection circuit apparatus for signals, wherein the selection circuit apparatus is a waveguide filter, comprising the following steps:
- determining (S1) a present temperature in the region of the selection circuit apparatus and a temperature drift that results in a frequency shift in a filter function of the selection circuit apparatus,
- determining (S2) a signal shift in the selection circuit apparatus on account of the present temperature, wherein the signal shift is a frequency shift,
- adding (S3) the signal shift to an input signal of the selection circuit apparatus in order to obtain a compensated signal in which the signal shift on account of the present temperature is compensated for, the input signal being an input spectrum, and
- removing (S4) the signal shift from an output signal of the selection circuit apparatus in order to obtain a corrected signal in which the compensation is corrected, the output signal being an output spectrum.

2. Method according to one of the preceding claims, wherein the signal shift is determined by an approximation calculation.

3. Method according to either of the preceding claims, wherein the signal shift is determined using a database.

4. Method according to one of the preceding claims, wherein the compensated signal and the corrected signal are updated by the selection circuit apparatus in sync in the forward and backward directions.

5. Method according to one of the preceding claims, additionally comprising
- determining a desired signal range of the input signal and/or of the output signal of the selection circuit apparatus on the basis of the purpose of use of the selection circuit apparatus, and
- adding a further signal shift to the input signal and/or to the output signal in order to shift the input signal and/or the output signal to the desired signal range.

6. Selection circuit apparatus that is a waveguide filter, designed to determine a signal shift in the selection circuit apparatus on account of a present temperature in the region of the selection circuit apparatus and a temperature drift that results in a frequency shift in a filter function of the selection circuit apparatus, wherein the signal shift is a frequency shift, to add the signal shift to an input signal of the selection circuit apparatus in order to obtain a compensated signal in which the signal shift on account of the present temperature is compensated for, the input signal being an input spectrum, and to remove the signal shift from an output signal of the selection circuit apparatus in order to obtain a corrected signal in which the compensation is corrected, the output signal being an output spectrum.

7. Selection circuit apparatus according to the preceding claim, wherein the selection circuit apparatus is a frequency multiplexer in the form of a passive filter, an active filter or a digital filter.

8. Selection circuit apparatus according to either of Claims 6 and 7, wherein the selection circuit apparatus is manufactured from a light metal, a light metal alloy, plastic and/or a fibre composite material.

9. Communication system, having a selection circuit apparatus according to one of Claims 6 to 8.

## Revendications

1. Procédé permettant de faire fonctionner un dispositif de circuit de sélection pour des signaux, le dispositif de circuit de sélection étant un filtre de guide d'ondes, présentant les étapes suivantes consistant à :
- déterminer (S1) une température actuelle au niveau du dispositif de circuit de sélection et une dérive de température aboutissant à un décalage de fréquence d'une fonction de filtre du dispositif de circuit de sélection,
- déterminer (S2) un décalage de signal du dispositif de circuit de sélection en raison de la température actuelle, le décalage de signal étant un décalage de fréquence,
- ajouter (S3) le décalage de signal à un signal d'entrée du dispositif de circuit de sélection afin d'obtenir un signal compensé dans lequel le décalage de signal est compensé en raison de la température actuelle, le signal d'entrée étant un spectre d'entrée, et
- éliminer (S4) le décalage de signal d'un signal de sortie du dispositif de circuit de sélection pour obtenir un signal corrigé dans lequel la compensation est corrigée, le signal de sortie étant un spectre de sortie.

2. Procédé selon l'une quelconque des revendications précédentes, dans lequel le décalage de signal est déterminé par un calcul par approximation.

3. Procédé selon l'une quelconque des revendications précédentes, dans lequel le décalage de signal est déterminé à l'aide d'une base de données.

4. Procédé selon l'une quelconque des revendications précédentes, dans lequel le signal compensé et le signal corrigé sont actualisés de manière synchronisée dans le temps dans la direction avant et arrière par le dispositif de circuit de sélection.

5. Procédé selon l'une quelconque des revendications précédentes, présentant en outre
- une détermination d'une plage de signaux souhaitée pour le signal d'entrée et/ou le signal de sortie du dispositif de circuit de sélection en fonction de l'usage prévu du dispositif de circuit de sélection, et
- un ajout d'un décalage de signal supplémentaire au signal d'entrée et/ou au signal de sortie pour décaler le signal d'entrée et/ou le signal de sortie dans la plage de signaux souhaitée.

6. Dispositif de circuit de sélection, qui est un guide d'ondes qui est configuré pour déterminer un décalage de signal du dispositif de circuit de sélection en raison d'une température actuelle au niveau du dispositif de circuit de sélection et une dérive de température aboutissant à un décalage de fréquence d'une fonction de filtre du dispositif de circuit de sélection, le décalage de signal étant un décalage de fréquence, pour ajouter le décalage de signal à un signal d'entrée du dispositif de circuit de sélection afin d'obtenir un signal compensé dans lequel le décalage de signal est compensé en raison de la température actuelle, le signal d'entrée étant un spectre d'entrée, et pour éliminer le décalage de signal d'un signal de sortie du dispositif de circuit de sélection afin d'obtenir un signal corrigé dans lequel la compensation est corrigée, le signal de sortie étant un spectre de sortie.

7. Dispositif de circuit de sélection selon la revendication précédente, dans lequel le dispositif de circuit de sélection est un multiplexeur de fréquence sous la forme d'un filtre passif, d'un filtre actif ou d'un filtre numérique.

8. Dispositif de circuit de sélection selon l'une quelconque des revendications 6 ou 7, dans lequel le dispositif de circuit de sélection est fabriqué à partir d'un métal léger, d'un alliage de métal léger, d'une matière plastique et/ou d'un matériau renforcé par des fibres.

9. Système de transmission de messages, présentant un dispositif de circuit de sélection selon l'une quelconque des revendications 6 à 8.
